Europäisches Patentamt

European Patent Office

Office européen des brevets

(19)

(11) **EP 1 197 987 A2**

(12) **EUROPEAN PATENT APPLICATION**

(43) Date of publication:
**17.04.2002 Bulletin 2002/16**

(51) Int Cl.⁷: $H01L\ 21/00$

(21) Application number: **01120329.6**

(22) Date of filing: **24.08.2001**

(84) Designated Contracting States:
**AT BE CH CY DE DK ES FI FR GB GR IE IT LI LU MC NL PT SE TR**
Designated Extension States:
**AL LT LV MK RO SI**

(30) Priority: **25.08.2000 JP 2000256134**

(71) Applicant: **CANON KABUSHIKI KAISHA Ohta-ku, Tokyo (JP)**

(72) Inventors:
• **Yanagita, Kazutaka**
**Tokyo (JP)**
• **Sakaguchi, Kiyofumi**
**Tokyo (JP)**

(74) Representative: **Pellmann, Hans-Bernd, Dipl.-Ing. Tiedtke-Bühling-Kinne & Partner GbR, TBK-Patent, Bavariaring 4 80336 München (DE)**

(54) **Method and apparatus for separating sample**

(57)    A sample or composite member such as a bonded substrate stack is appropriately separated. A separating apparatus (500) has a wedge-shaped nozzle (503) for injecting a fluid, and an air cylinder (505) for butting the wedge-shaped nozzle (503) against a bonded substrate stack (50) or inserting the nozzle (503) into the bonded substrate stack (50). In a state in which the wedge-shaped nozzle (503) is being butted against the bonded substrate stack (50) or inserted into the bonded substrate stack (50), the bonded substrate stack (50) can be separated at a porous layer by injecting a fluid from the wedge-shaped nozzle (503).

**F I G.  2**

EP 1 197 987 A2

## Description

### FIELD OF THE INVENTION

The present invention relates to a method and apparatus for separating a sample such as a bonded substrate stack, a transfer film transfer method, a substrate manufacturing method, and a semiconductor device and a method of manufacturing the same.

### BACKGROUND OF THE INVENTION

A substrate (SOI substrate) having an SOI (Silicon On Insulator) structure is known as a substrate having a single-crystal Si layer on an insulating layer. A device using this SOI substrate has many advantages that cannot be achieved by ordinary Si substrates. Examples of the advantages are as follows.

(1) The integration degree can be increased because dielectric isolation is easy.
(2) The radiation resistance can be increased.
(3) The operating speed of the device can be increased because the stray capacitance is small.
(4) No well step is necessary.
(5) Latch-up can be prevented.
(6) A complete depletion type field effect transistor can be formed by thin film formation.

Since an SOI structure has the above various advantages, researches have been made on its formation method for several decades.

As a method, an SOI structure is formed by bonding a single-crystal Si substrate to another thermally oxidized single-crystal Si substrate by annealing or an adhesive. In this method, an active layer for forming a device must be uniformly thin. More specifically, a single-crystal Si substrate having a thickness of several hundred micron must be thinned down to the micron order or less.

To thin the substrate, polishing or selective etching can be used.

A single-crystal Si substrate can hardly be uniformly thinned by polishing. Especially, in thinning to the submicron order, the variation range is several ten %. As the wafer size becomes large, this difficulty becomes more pronounced.

Selective etching is effective to uniformly thin the substrate. However, the selectivity ratio is as low as about $10^2$, the surface planarity after etching is poor, and the crystallinity of the SOI layer is unsatisfactory.

The present applicant has disclosed a new SOI technique in Japanese Patent Laid-Open No. 5-21338. In this technique, a first substrate obtained by forming a porous layer on a single-crystal Si substrate and a non-porous single-crystal layer on its surface is bonded to a second substrate via an insulating layer. After this, the bonded substrate stack is separated into two substrates at the porous layer, thereby transferring the non-porous single-crystal layer to the second substrate. This technique is advantageous because the film thickness uniformity of the SOI layer is good, the crystal defect density in the SOI layer can be decreased, the surface planarity of the SOI layer is good, no expensive manufacturing apparatus with special specifications is required, and SOI substrates having about several hundred-Å to 10-μm thick SOI films can be manufactured by a single manufacturing apparatus.

The present applicant has also disclosed, in Japanese Patent Laid-Open No. 7-302889, a technique of bonding first and second substrates, separating the first substrate from the second substrate without breaking the first substrate, smoothing the surface of the separated first substrate, forming a porous layer again, and reusing the substrate. Since the first substrate is not wasted, this technique is advantageous in largely reducing the manufacturing cost and simplifying the manufacturing process.

To separate the bonded substrate stack into two substrates without breaking the first and second substrates, the following methods are available: the two substrates are pulled in opposite directions while applying a force in a direction perpendicular to the bonding interface; a shearing force is applied parallel to the bonding interface (for example, the two substrates are moved in opposite directions in a plane parallel to the bonding interface, or the two substrates are rotated in opposite directions while applying a force in the circumferential direction); pressure is applied in a direction perpendicular to the bonding interface; a wave energy such as an ultrasonic wave is applied to the separation region; a peeling member (e.g., a sharp blade such as a knife) is inserted into the separation region parallel to the bonding interface from the side surface side of the bonded substrate stack; the expansion energy of a substance filling the pores of the porous layer functioning as the separation region is used; the porous layer functioning as the separation region is thermally oxidized from the side surface of the bonded substrate stack to expand the volume of the porous layer and separate the substrates; and the porous layer functioning as the separation region is selectively etched from the side surface of the bonded substrate stack to separate the substrates.

Porous Si was found in 1956 by Uhlir et al. who were studying electropolishing of semiconductors (A. Uhlir, Bell Syst. Tech. J., vol. 35, 333 (1956)). Porous Si can be formed by anodizing an Si substrate in an HF solution.

Unagami et al. studied the dissolution reaction of Si upon anodizing and reported that holes were necessary for anodizing reaction of Si in an HF solution, and the reaction was as follows (T. Unagami, J. Electrochem. Soc., vol. 127, 476 (1980)).

$$Si + 2HF + (2 - n)\,e^+ \rightarrow SiF_2 + 2H^+ + ne^-$$

$$SiF_2 + 2HF \rightarrow SiF_4 + H_2$$

$$SiF_4 + 2HF \rightarrow H_2SiF_6$$

or

$$Si + 4HF + (4 - \lambda)e^+ \rightarrow SiF_4 + 4H^+ + \lambda e^-$$

$$SiF_4 + 2HF \rightarrow H_2SiF_6$$

where $e^+$ and $e^-$ represent a hole and an electron, respectively, and $n$ and $\lambda$ are the number of holes necessary to dissolve one Si atom. According to them, when $n > 2$ or $\lambda > 4$, porous Si is formed.

The above fact suggests that p-type Si having holes is converted into porous Si while n-type Si is not converted. The selectivity in this conversion has been reported by Nagano et al. and Imai (Nagano, Nakajima, Anno, Onaka, and Kajiwara, IEICE Technical Report, vol. 79, SSD79-9549 (1979)), (K. Imai, Solid-State Electronics, vol. 24, 159 (1981)).

However, it has also been reported that n-type at a high concentration is converted into porous Si (R. P. Holmstrom and J.Y. Chi, Appl. Phys. Lett., vol. 42, 386 (1983)). Hence, it is important to select a substrate which can be converted into a porous Si substrate independently of p- or n-type.

To form a porous layer, instead of the above anodizing method, for example, a method of implanting ions into a silicon substrate may also be used.

For example, in the method described in Japanese Patent Laid-Open No. 5-21338, i.e., the method of preparing a substrate (to be referred to as a bonded substrate stack hereinafter) by bonding a first substrate having a non-porous layer such as a single-crystal Si layer on a porous layer to a second substrate via an insulating layer, and separating the bonded substrate stack at the porous layer so as to transfer the non-porous layer formed on the first substrate side to the second substrate, the technique of separating the bonded substrate stack is very important.

SUMMARY OF THE INVENTION

The present invention has been made in consideration of the above situation, and has as its object to appropriately separate, e.g., a sample or composite member such as a bonded substrate stack.

According to the first aspect of the present invention, there is provided a sample separating apparatus characterized by comprising a nozzle for injecting a fluid, and an operation section for butting the nozzle against a sample or inserting the nozzle into the sample, wherein in a state in which the nozzle is being butted against the sample or inserted into the sample, the sample is separated while injecting the fluid from the nozzle.

Preferably, the sample has a separation layer, and the operation section butts the nozzle against a peripheral portion of the separation layer of the sample or inserts the nozzle into the peripheral portion of the separation layer of the sample. Alternatively, preferably, the sample has a separation layer and a concave portion on a side surface, and the operation section butts the nozzle against the concave portion of the sample or inserts the nozzle into the concave portion of the sample.

The nozzle preferably has a wedge-shaped portion.

The nozzle preferably has a fluid injection port at a distal end.

Preferably, the separating apparatus according to the first aspect of the present invention further comprises a rotary drive section for rotating the sample relative to the nozzle, and in the state in which the nozzle is being butted against the sample or inserted into the sample, the sample is separated while rotating the sample relative to the nozzle and injecting the fluid from the nozzle.

Either a gas or a liquid can be used as the fluid.

The separation layer is preferably a fragile layer, e.g., a layer formed by anodization or ion implantation.

According to the second aspect of the present invention, a sample separating method characterized by comprising the operation step of butting an injection nozzle against a sample or inserting the nozzle into the sample, and the separation step of, in a state in which the nozzle is being butted against the sample or inserted into the sample, separating the sample while injecting a fluid from the nozzle.

Preferably, the sample has a separation layer inside, and in the operation step, the nozzle is butted against a peripheral portion of the separation layer of the sample or inserted into the peripheral portion of the separation layer of the sample. Alternatively, preferably, the sample has a separation layer inside and a concave portion on a side surface, and in the operation step, the nozzle is butted against the concave portion of the sample or inserted into the concave portion of the sample.

The nozzle preferably has a wedge-shaped portion. In addition, the nozzle preferably has a fluid injection port at a distal end.

In the separation step, preferably, in the state in which the nozzle is being butted against the sample or inserted into the sample, the sample is separated while rotating the sample relative to the nozzle and injecting the fluid from the nozzle.

Either a gas or a liquid can be used as the fluid.

The separation layer is preferably a fragile layer, e.g., a layer formed by anodization or ion implantation.

According to the third aspect of the present invention, there is provided a transfer method of transferring a transfer layer on a surface of a first member to a second member, characterized by comprising the preparation step of preparing a composite member by bringing the first member having a separation layer and the transfer layer on the separation layer into tight contact with the second member, the operation step of butting an injection nozzle against the composite member or inserting the nozzle into the composite member, and the separation step of, in a state in which the nozzle is being butted against the composite member or inserted into the composite member, separating the composite member at the separation layer while injecting a fluid from the nozzle, thereby transferring the transfer layer of the first member to the second member.

According to the fourth aspect of the present invention, there is provided a substrate manufacturing method characterized by comprising the preparation step of preparing a bonded substrate stack by bonding a first substrate having a separation layer and a transfer layer on the separation layer to a second substrate, the operation step of butting an injection nozzle against the bonded substrate stack or inserting the nozzle into the bonded substrate stack, and the separation step of, in a state in which the nozzle is being butted against the bonded substrate stack or inserted into the bonded substrate stack, separating the bonded substrate stack at the separation layer while injecting a fluid from the nozzle, thereby transferring the transfer layer of the first substrate to the second substrate.

The transfer layer preferably includes a single-crystal Si layer, and in addition to the single-crystal Si layer, an insulating layer on the single-crystal Si layer.

The nozzle preferably has a wedge-shaped portion. Additionally, the nozzle preferably has a fluid injection port at a distal end.

In the separation step, preferably, in the state in which the nozzle is being butted against the bonded substrate stack or inserted into the bonded substrate stack, the bonded substrate stack is separated while rotating the bonded substrate stack relative to the nozzle and injecting the fluid from the nozzle.

Either a gas or a liquid can be used as the fluid.

The separation layer is preferably a fragile layer, e.g., a layer formed by anodization or ion implantation.

According to the fifth aspect of the present invention, there is provided a semiconductor device manufacturing method characterized by comprising the step of preparing an SOI substrate using the substrate manufacturing method according to the fourth aspect of the present invention, and the step of element-isolating an SOI layer of the SOI substrate and forming a transistor on the element-isolated SOI layer.

The transistor may be either a partial depletion type FET or a complete depletion type FET.

According to the sixth aspect of the present invention, there is provided a nozzle used to separate a sample, characterized by comprising a wedge-shaped portion having a fluid injection port at a distal end.

According to the seventh aspect of the present invention, there is provided a nozzle used to separate at a separation layer a sample having the separation layer inside, characterized by comprising a wedge-shaped portion having a fluid injection port at a distal end.

Other features and advantages of the present invention will be apparent from the following description taken in conjunction with the accompanying drawings, in which like reference characters designate the same or similar parts throughout the figures thereof.

BRIEF DESCRIPTION OF THE DRAWINGS

The accompanying drawings, which are incorporated in and constitute a part of the specification, illustrate embodiments of the invention and, together with the description, serve to explain the principles of the invention.

Figs. 1A to 1E are schematic views for explaining the step of forming a porous layer in a substrate manufacturing method according to a preferred embodiment of the present invention;

Fig. 2 is a view showing the arrangement of a separating apparatus according to a preferred embodiment of the present invention;

Fig. 3 is a view showing a preferred arrangement of a wedge-shaped nozzle;

Fig. 4 is an enlarged view showing part of the separating apparatus shown in Fig. 2;

Fig. 5 is an enlarged view showing part of the separating apparatus shown in Fig. 2;

Fig. 6 is a view schematically showing a state wherein bonded substrate stack separation processing progresses;

Fig. 7 is a view schematically showing a state wherein bonded substrate stack separation processing progresses;

Fig. 8 is a view schematically showing a state wherein bonded substrate stack separation processing progresses;

Fig. 9 is a view showing part of a separating apparatus according to another embodiment of the present invention; and

Figs. 10A to 10D are sectional views showing a method of manufacturing a semiconductor device using a semiconductor substrate manufactured using the substrate manufacturing method according to the preferred embodiment of the present invention.

DETAILED DESCRIPTION OF THE PREFERRED EMBODIMENTS

Preferred embodiments of the present invention will be described below with reference to the accompanying drawings.

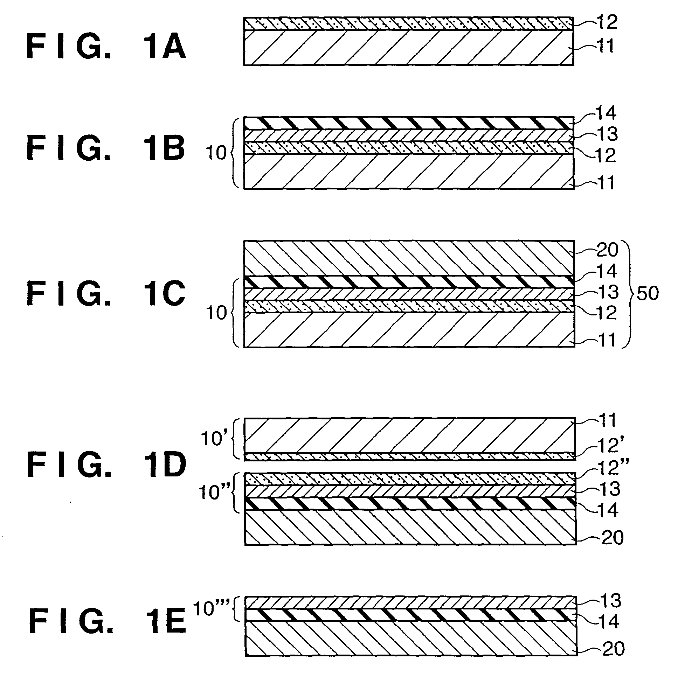

Figs. 1A to 1E are schematic views for explaining a method of manufacturing a substrate having, e.g., an SOI structure according to a preferred embodiment of the present invention.

In the step shown in Fig. 1A, a single-crystal Si substrate 11 to be used to form a first substrate (seed wafer) 10 is prepared, and a porous Si layer 12 serving as a separation layer is formed on the major surface of the single-crystal Si substrate 11. The porous Si layer 12 can be formed by, e.g., anodizing the single-crystal Si substrate 11 in an electrolyte solution (anodizing solution).

As the electrolyte solution, for example, a solution containing hydrogen fluoride, a solution containing hydrogen fluoride and ethanol, a solution containing hydrogen fluoride and isopropyl alcohol, or the like can be used. More specifically, as the electrolyte solution, for example, a solution mixture containing an HF aqueous solution (HF concentration = 49 wt%) and ethanol at a volume ratio of 2 : 1 can be used.

The porous Si layer 12 may have a multilayered structure including two or more layers with different porosities. The porous Si layer 12 having a multilayered structure preferably includes the first porous Si layer with the first porosity on the surface side, and, under the first porous Si layer, the second porous Si layer with the second porosity higher than the first porosity. With such a multilayered structure, a non-porous layer 13 free from defects can be formed on the first porous Si layer in the step of forming the non-porous layer 13 later, and a bonded substrate stack can be separated at a desired position in the separation step layer. The first porosity is preferably 10% to 30% and, more preferably, 15% to 25%. The second porosity is preferably 35% to 70% and, more preferably, 40% to 60%.

When the above solution mixture (49 wt% hydrofluoric acid: ethanol = 2 : 1) is used as the electrolyte solution, preferably, for example, the first layer (surface side) is formed at a current density of 8 mA/cm$^2$ for a process time of 5 to 11 min, and the second layer (inner surface side) is formed at a current density of 23 to 33 mA/cm$^2$ for a process time of 80 sec to 2 min.

Next, at least one of the following steps (1) to (4) is preferably executed. The steps (1) and (2) are preferably executed in this order. More preferably, the steps (1), (2), and (3), or (1), (2), and (4) are executed in this order. Most preferably, the steps (1), (2), (3), and (4) are executed in this order.

(1) Step of forming protective film on porous walls in porous Si layer (pre-oxidation step)

In this step, a protective film such as an oxide film or nitride film is formed on the porous walls in the porous Si layer 12, thereby preventing any increase in porous size by later annealing. The protective film can be formed by performing annealing in an oxygen atmosphere (preferably at, e.g., 200°C to 700°C, and more preferably at 300°C to 500°C). After that, the oxide film or the like formed on the surface of the porous Si layer 12 is preferably removed. This can be done by, e.g., exposing the surface of the porous Si layer 12 to a solution containing hydrofluoric acid.

(2) Hydrogen baking step (pre-baking step)

In this step, the first substrate 10 on which the porous Si layer 12 is formed is annealed in a reduction atmosphere containing hydrogen at 800°C to 1,200°C. With this annealing, pores on the surface of the porous Si layer 12 can be sealed to some extent. If a native oxide film is present on the surface of the porous Si layer 12, it can be removed.

(3) Trace material supply step (pre-injection step)

When the non-porous layer 13 is to be grown on the porous Si layer 12, the non-porous layer 13 is preferably grown at a low speed by supplying a trace of raw material substance of the non-porous layer 13 at the initial stage of growth. With this growing method, atomic migration on the surface of the porous Si layer 12 is promoted, and pores on the surface of the porous Si layer 12 can be sealed. More specifically, the supply of the raw material is controlled such that the growth rate becomes 20 nm/min or less, preferably 10 nm/min or less, and more preferably, 2 nm/min or less.

(4) High-temperature baking step (intermediate baking step)

When annealing is executed in a reduction atmosphere containing hydrogen at a temperature higher than that in the above hydrogen baking step and/or trace material supply step, further sealing and flattening of the porous Si layer 12 can be realized.

At the first stage of the step shown in Fig. 1B, the first non-porous layer 13 is formed on the porous Si layer 12. As the first non-porous layer 13, an Si layer such as a single-crystal Si layer, poly-Si layer, or amorphous Si layer, Ge layer, SiGe layer, SiC layer, C layer, GaAs layer, GaN layer, AlGaAs layer, InGaAs layer, InP layer, or InAs layer can be used.

At the second stage of the step shown in Fig. 1B, an SiO$_2$ layer (insulating layer) 14 as the second non-porous layer is formed on the first non-porous layer 13. With this process, the first substrate 10 is obtained.

The SiO$_2$ layer 14 can be formed, e.g., in an O$_2$/H$_2$ atmosphere at 1,100°C for 10 to 33 min.

In the step shown in Fig. 1C, a second substrate (handle wafer) 20 is prepared and brought into tight contact with the first substrate 10 at room temperature while making the insulating layer 14 face the second substrate 20, thereby forming a bonded substrate stack 30.

The SiO$_2$ layer 14 can be formed either on the single-crystal Si layer 13 side, or on the second substrate 20, or on both the single-crystal Si layer 13 and the second substrate 20 as long as the state shown in Fig. 1C is obtained when the first and second substrates are brought into tight contact with each other. However, when the insulating layer 14 is formed on the first nonporous layer (e.g., a single-crystal Si layer) 13 side serving as an active layer, as described above, the bonding interface between the first substrate 10 and the second substrate 20 can be separated from the active layer, and a semiconductor substrate such as an SOI substrate with a higher quality can be obtained.

After the substrates 10 and 20 are completely brought into tight contact, processing of strengthening bonding between the substrates is preferably executed. As an example of this processing, processing of, e.g., 1) executing annealing in an N$_2$ atmosphere at 1,100°C for 10 min and 2) executing annealing (oxidation) in an O$_2$/H$_2$ atmosphere at 1,100°C for 50 to 100 min is preferably performed. In addition to this processing, or in place of this processing, anodic bonding and/or compression may be executed.

As the second substrate 20, an Si substrate, a substrate obtained by forming an SiO$_2$ layer on an Si substrate, a transparent substrate formed from quartz or the like, or a sapphire substrate can be used. However, a substrate of another type which has a sufficiently flat surface to be bonded may be used as the second substrate 20.

In the step shown in Fig. 1D, the bonded substrate stack 30 is separated at the fragile porous layer 12 with a low mechanical strength using a separating method to be described later.

In the step shown in Fig. 1E, a porous layer 12b on the single-crystal Si substrate 11 on a separated first substrate 10' is selectively removed by etching or the like. The single-crystal Si substrate 11 obtained in this way can be reused as a substrate for forming the first substrate 10 or as the second substrate 20.

As a bonded substrate stack, a substrate prepared by the following method may be employed. First, a semiconductor substrate represented by a single-crystal Si substrate such as a mirror wafer or epitaxial wafer is prepared. An insulating film such as a thermal silicon oxide film is formed on the surface of the substrate, as needed. Next, ions such as hydrogen ions or rare gas ions are implanted into the substrate by ion implantation using a line beam or plasma immersion, thereby forming a relatively heavily doped ion implantation layer serving as a separation layer at a predetermined depth from the surface. The first substrate is obtained in the above manner.

Next, the second substrate is prepared according to the same procedure as described above and bonded to the first substrate in accordance with the above-described bonding method. With this process, a bonded substrate stack having a layer to be transferred (transfer layer) inside can be obtained.

The ion implantation layer is distorted or contains defects or pores formed from microcavities due to the implanted ions. Such an ion implantation layer has a relatively low mechanical strength and therefore functions as a separation layer.

A separating method and apparatus suitable for the step shown in Fig. 1D will be described next. In this separating method, a wedge is butted against the peripheral portion of a bonded substrate stack or inserted into the porous layer of the bonded substrate stack, and in this state, a fluid (a liquid or gas) is injected from the wedge, thereby separating the bonded substrate stack at the porous layer serving as a separation layer.

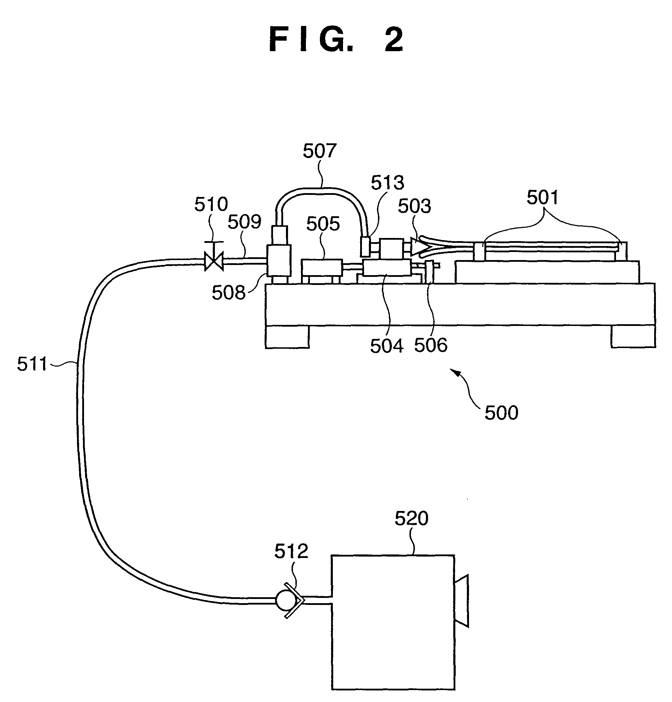

Fig. 2 is a view showing the arrangement of a separating apparatus according to a preferred embodiment of the present invention. In a separating apparatus 500, a bonded substrate stack 50 as a sample or composite member to be separated is supported on a support table 502 by a plurality of (e.g., four) support pins 501. Each support pin 501 has a stairwise shape. The bonded substrate stack 50 is supported at its side and lower surfaces by the stairwise shape of each support pin 501 so that the vertical and horizontal positions of the bonded substrate stack 50 are determined. Instead, the bonded substrate stack 50 may be sandwiched from the upper and lower sides and supported.

The separating apparatus 500 has a wedge-shaped nozzle 503. The wedge-shaped nozzle 503 is fixed on a direct-acting guide 504 driven by an air cylinder 505. When the air cylinder 505 pushes its piston rod, the wedge-shaped nozzle 503 moves forward. When the air cylinder 505 retracts its piston rod, the wedge-shaped nozzle 503 moves backward. The wedge-shaped nozzle 503 that moves forward is butted against a concave portion (a groove formed throughout the perimeter of the bonded substrate stack by beveling of the first substrate and that of the second substrate, or a portion that recesses from the peripheral surface of the bonded substrate stack) of the peripheral portion of the bonded substrate stack 50, or inserted into the porous layer of the bonded substrate stack 50 toward the center of the bonded substrate stack 50. The insertion amount of the wedge-shaped nozzle 503 inserted into the bonded substrate stack 50 is preferably smaller than the length of the peripheral removed portion of a substrate (e.g., a SOI substrate) that can be manufactured by the step shown in Figs. 1A to 1E, and preferably, e.g., 3 mm or less. The maximum moving amount of the direct-acting guide 504 is limited by a stopper 506, thus limiting the maximum insertion amount of the wedge-shaped nozzle 503. That is, the stopper 506 functions to limit the insertion amount of the wedge-shaped nozzle 503 into the bonded substrate stack 50.

In this embodiment, the wedge-shaped nozzle 503 is operated by an operation portion formed from the air cylinder 505 and direct-acting guide 504, thereby butting the wedge-shaped nozzle 503 against the concave portion of the peripheral portion of the bonded substrate stack 50 or inserting the wedge-shaped nozzle 503 into the porous layer of the bonded substrate stack 50. Instead, the wedge-shaped nozzle 503 may be butted against the concave portion of the peripheral portion of the bonded substrate stack 50 or inserted into the porous layer of the bonded substrate stack 50 by operating the bonded substrate stack 50.

A compressed fluid is supplied from a compressor 520 to the wedge-shaped nozzle 503 through a check valve 512, pipe 511, two-way valve 510, pipe 509, coupling 508, pipe 507, and coupling 513. The wedge-shaped nozzle 503 has an injection port at its distal end and injects the fluid from the injection port. As the fluid, a gas such as air or a liquid such as water can be used. When air is employed as a fluid, the compressor 520 only need receive atmosphere, and the structure can be simplified.

Fluid injection from the wedge-shaped nozzle 503 is controlled by the two-way valve 510. The check valve 512 is inserted between the two-way valve 510 and the compressor 520 so that any decrease in pressure of the fluid to be supplied to the wedge-shaped nozzle 503 can be prevented.

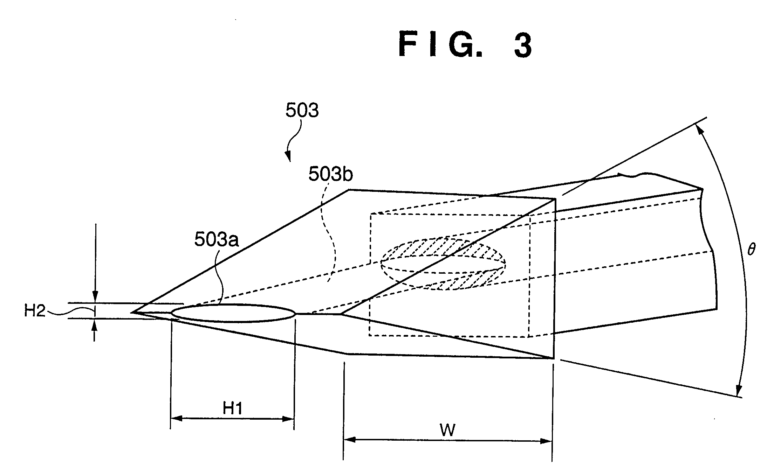

Fig. 3 is a view showing a preferred arrangement of the wedge-shaped nozzle. The wedge-shaped nozzle 503 with the preferred arrangement has a wedge shape whose width W is 10 mm and angle θ of the distal end is 20°. The wedge-shaped nozzle 503 has an injection port 503a for injecting a fluid, and a path 503b that communicates the injection port 503a with the pipe 507. The injection port 503a has, e.g., an elliptical shape with a major axis H1 of 5 mm and a minor axis H2 of 0.5 mm. The optical structure of the wedge-shaped nozzle 503 changes depending on conditions including the size and structure of the bonded substrate stack 50, the type or pressure of the fluid, and the insertion amount of the wedge-shaped nozzle 503 into the bonded substrate stack 50.

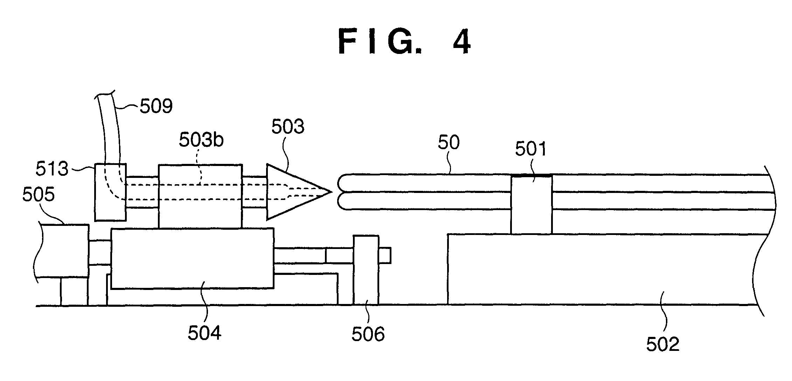

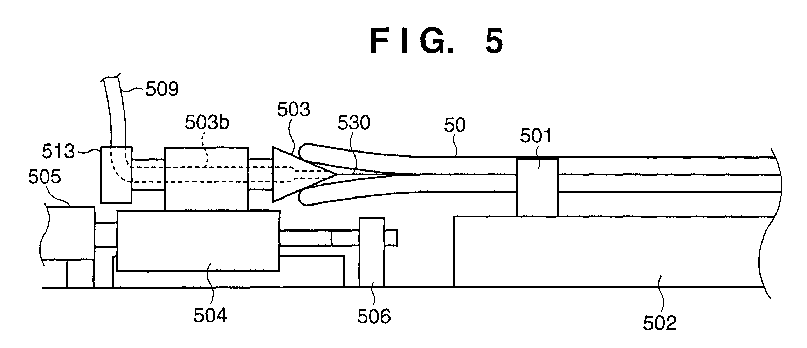

Figs. 4 and 5 are partial enlarged views of the separating apparatus shown in Fig. 2. Fig. 4 is a view showing a state before the start of separation processing. Fig. 5 is a view showing a state during separation processing.

Separation processing according to a preferred embodiment of the present invention will be described below with reference to Figs. 2 to 5.

First, as shown in Fig. 4, the bonded substrate stack 50 is placed on the support table 502 such that the bonded substrate stack 50 is supported by the stairwise portions of the plurality of support pins 501. This operation can be done by, e.g., a substrate transfer robot.

The wedge-shaped nozzle 503 is moved forward and butted against the concave portion of the peripheral portion of the bonded substrate stack 50 or inserted into the concave portion of the bonded substrate stack 50 by driving the air cylinder 505. As described above, the insertion amount of the wedge-shaped nozzle 503 into the bonded substrate stack 50 is preferably smaller than the length of the peripheral removed portion of a substrate (e.g., an SOI substrate) that can be manufactured by the step shown in Figs. 1A to 1E, and preferably, e.g., 3 mm or less. When the insertion amount has reached a predetermined amount, the bonded substrate stack 50 is partially separated at the porous layer. The insertion amount need not always be so large as to reach the porous layer.

In the state wherein the wedge-shaped nozzle 503 is butted against the concave portion of the bonded substrate stack 50 or inserted into the porous layer of the bonded substrate stack 50 (Fig. 5), a fluid is injected from the injection port 503a at the distal end of the wedge-shaped nozzle 503. Fluid injection is executed according to the following procedure. First, the compressor 520 is operated to feed the compressed fluid to the two-way valve 510. After the fluid pressure stabilizes, the two-way valve 510 is opened to feed the compressed fluid to the wedge-shaped nozzle 503. When a gas such as air is employed as the fluid, the fluid pressure is preferably, e.g., about 1 to 10 $kgf/cm^2$. When a liquid such as water is employed as the fluid, the fluid pressure is preferably, e.g., about 0.1 to 5 $kgf/cm^2$.

As the fluid is injected, the bonded substrate stack 50 is gradually separated at the porous layer from the region near the distal end of the wedge-shaped nozzle 503 to the periphery and is finally separated across the whole region of the porous layer. When a gas was used as a fluid, and its pressure was set at 5 $kgf/cm^2$, a 6-inch bonded substrate stack was completely separated in about 5 min. When a liquid was used as a fluid, and its pressure was set at 2.5 $kgf/cm^2$, a 6-inch bonded substrate stack was completely separated in about 1 min.

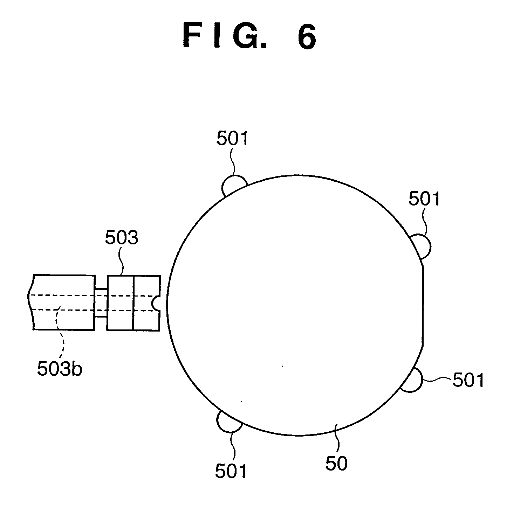

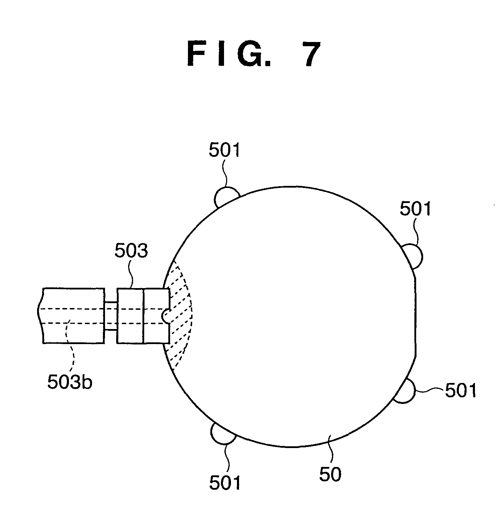

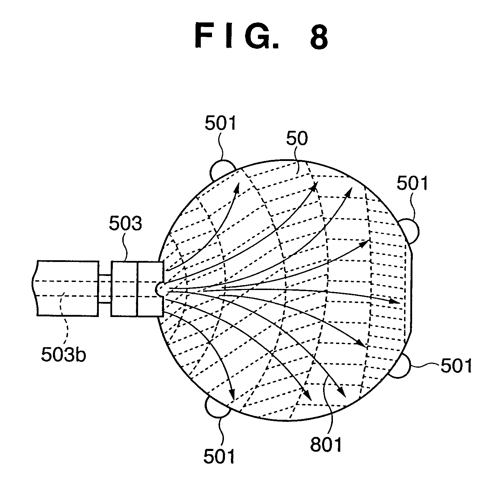

Figs. 6 to 8 are views schematically showing states wherein bonded substrate stack separation processing progresses. Fig. 6 corresponds to the state shown in Fig. 4. Fig. 7 corresponds to the state shown in Fig. 5. Fig. 8 schematically shows a completely separated bonded substrate stack. Referring to Figs. 7 and 8, a hatched region 60 represents an already separated region of the bonded substrate stack. Referring to Fig. 8, arrows 801 indicate the flow of the fluid.

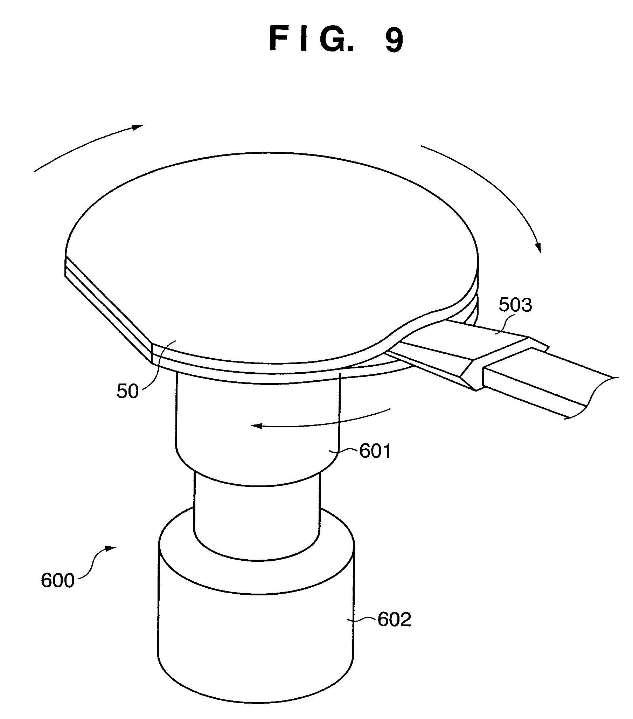

Fig. 9 is a view showing part of a separating apparatus according to another embodiment of the present invention. Like the separating apparatus 500, a separating apparatus 600 also has an air cylinder 505 and direct-acting guide 504 for driving a wedge-shaped nozzle 503, a compressor 520 for supplying a fluid to the injection nozzle 503, and the like.

As shown in Fig. 9, the separating apparatus 600 has a rotating table 601 for chucking and supporting a bonded substrate stack 50, and a motor 602 for rotating the rotating table 601. The bonded substrate stack 50 is separated using the wedge-shaped nozzle 503 while being rotated by the motor 602.

The separating apparatus 600 is an example of a separating apparatus for separating the bonded substrate stack 50 while rotating it relative to the wedge-shaped nozzle 503. In place of the separating apparatus 600, a separating apparatus for rotating the wedge-shaped nozzle 503 along the periphery of the bonded substrate stack 50 may be employed.

A sample may be separated in the following way. That is, the wedge-shaped nozzle is inserted into or butted against the concave portion of the side surface of the sample which stands still. The sample is partially separated by injecting a fluid, and then, the nozzle is removed, and the fluid is injected into the sample from the outside while rotating the sample. Alternatively, the sample may be separated in the following way. That is, the wedge-shaped nozzle is inserted into the peripheral portion of the sample, and then, the fluid is injected into peripheral portion while removing the nozzle from the sample but before the nozzle is not completely removed from the sample. After the nozzle is completely removed from the sample, the sample can be rotated while the fluid is injected into the sample.

[Example of Semiconductor Device]

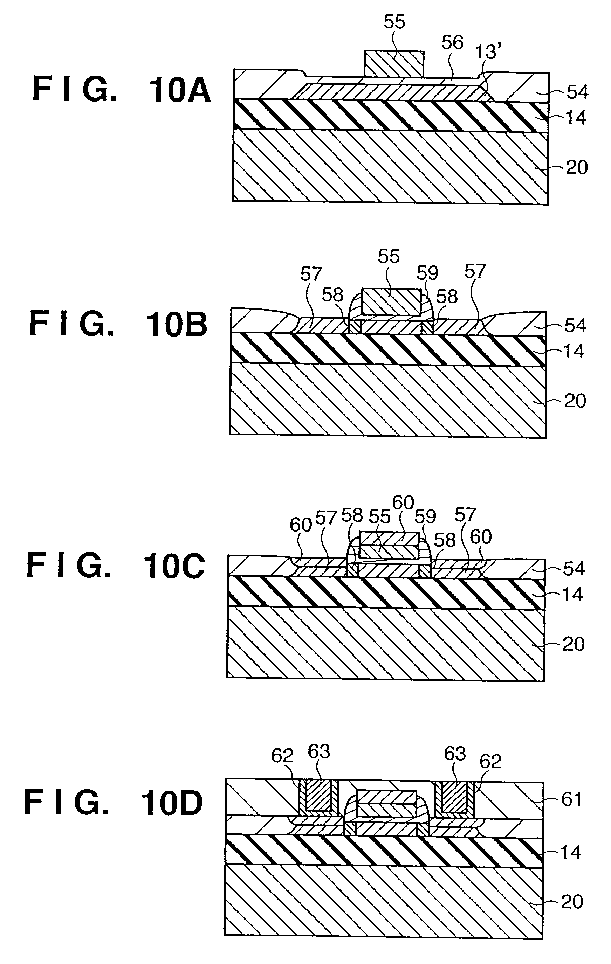

A semiconductor device using a semiconductor substrate that can be manufactured by the above substrate manufacturing method (Figs. 1A to 1E) and a method of manufacturing the device will be described next with reference to Figs. 10A to 10D.

Figs. 10A to 10D are sectional views showing a method of manufacturing a semiconductor device using a semiconductor substrate that can be manufactured using the substrate manufacturing method according to the preferred embodiment of the present invention.

First, an SOI substrate having a semiconductor layer as a non-porous layer 13 and an insulating layer as a non-porous layer 14 is manufactured using the above substrate manufacturing method. An active region 13' where a transistor is to be formed and an element isolation region 54 are formed by a method of patterning the non-porous semiconductor layer (SOI layer) 13 on the buried insulating layer 14 into an island shape or an oxidation method called LOCOS (Fig. 10A).

Next, a gate insulating film 56 is formed on the surface of the SOI layer (Fig. 10A). Examples of the material of the gate insulating film 56 are silicon oxide, silicon nitride, silicon oxynitride, aluminum oxide, tantalum oxide, hafnium oxide, titanium oxide, scandium oxide, yttrium oxide, gadolinium oxide, lanthanum oxide, zirconium oxide, and a glass mixture thereof. The gate insulating film 56 can be formed by, e.g., oxidizing the surface of the SOI layer or depositing an appropriate substance on the surface of the SOI layer by CVD or PVD.

A gate electrode 55 is formed on the gate insulating film 56 (Fig. 10A). The gate electrode 55 can be formed from, e.g., polysilicon doped with a p- or n-type impurity, a metal such as tungsten, molybdenum, titanium, tantalum, aluminum, or copper or an alloy containing at least one of them, a metal silicide such as molybdenum silicide, tungsten silicide, or cobalt silicide, or a metal nitride such as titanium nitride, tungsten nitride, or tantalum nitride. The gate insulating film 56 may be formed by stacking a plurality of layers formed from different materials. The gate electrode 55 can be formed either by, e.g., a method called Salicide (self-align silicide) or by a method called a damascene gate process, or by any other method. With the above process, a structure shown in Fig. 10A is obtained.

Next, an n-type impurity such as phosphor, arsenic, or antimony or a p-type impurity such as boron is doped into the active region 13', thereby forming relatively lightly-doped source and drain regions 58 (Fig. 10B). The impurity can be doped by, e.g., ion implantation and annealing.

An insulating film is formed to cover the gate electrode 55 and then etched back, thereby forming a side wall 59 on the side surface of the gate electrode 55.

An impurity having the same conductivity type as described above is doped into the active region 13' again, thereby forming relatively heavily-doped source and drain regions 57. With the above process, a structure shown in Fig. 10B is obtained.

A metal silicide layer 60 is formed on the upper surface of the gate electrode 55 and on the upper surfaces of the source and drain regions 57. Examples of the material of the metal silicide layer 60 are nickel silicide, titanium silicide, cobalt silicide, molybdenum silicide, and tungsten silicide. Such a silicide can be formed by depositing a metal on the upper surface of the gate electrode 55 and on the upper surfaces of the source and drain regions 57, performing annealing to cause the metal to react with underlying silicon, and removing an unreacted portion of the metal using an etchant such as sulfuric acid. The surface of the silicide layer may be nitrided as needed. With the above process, a structure shown in Fig. 10C is obtained.

An insulating film 61 is formed on the upper surface of the gate electrode and on the upper surfaces of the source and drain regions, which are converted into a silicide (Fig. 10D). As the material of the insulating film 61, silicon oxide containing phosphor and/or boron can be used.

Contact holes are formed in the insulating film 61 by CMP, as needed. When photolithography using a KrF excimer laser, ArF excimer laser, $F_2$ excimer laser, electron beam, or X-rays is used, a rectangular contact hole with a side smaller than 0.25 μm or a circular contact hole having a diameter smaller than 0.25 μm can be formed.

Next, the contact holes are filled with a conductor. To fill the contact holes with a conductor, a film of a refractory metal or a nitride thereof, which serves as a barrier metal, is formed on the inner surface of each contact hole, and after that, a conductor 63 such as a tungsten alloy, aluminum, aluminum alloy, copper, or copper alloy is deposited by CVD, PVD, or plating. A conductor may be deposited to a level higher than the upper surface of the insulating film 61 and removed by etch back or CMP. Alternatively, before the contact holes are filled with the conductor, the surface of the silicide layer in the source and drain regions, which is exposed to the bottom portion of each contact hole, may be nitrided. With the above process, a transistor such as an FET can be formed on the SOI layer, and a semiconductor device having a transistor with a structure shown in Fig. 10D can be obtained.

When the thickness and impurity concentration of the active layer (SOI layer) 13' are defined such that a depletion layer formed upon applying a voltage to the gate electrode reaches the upper surface of the buried insulating layer 14, the formed transistor operates a complete depletion type transistor. When the thickness and impurity concentration of the active layer (SOI layer) 13' are defined such that the depletion layer does not reach the upper surface of the buried insulating layer 14, the formed transistor operates a partial depletion type transistor.

According to the present invention, a composite member such as a bonded substrate stack can be appropriately separated at a separation layer such as a porous layer.

As many apparently widely different embodiments of the present invention can be made without departing from the spirit and scope thereof, it is to be understood that the invention is not limited to the specific embodiments thereof except as defined in the appended claims.

A sample or composite member such as a bonded substrate stack is appropriately separated. A separating apparatus (500) has a wedge-shaped nozzle (503) for injecting a fluid, and an air cylinder (505) for butting the wedge-shaped nozzle (503) against a bonded substrate stack (50) or inserting the nozzle (503) into the bonded substrate stack (50). In a state in which the wedge-shaped nozzle (503) is being butted against the bonded substrate stack (50) or inserted into the bonded substrate stack (50), the bonded substrate stack (50) can be separated at a porous layer by injecting a fluid from the wedge-shaped nozzle (503).

**Claims**

**1.** A sample separating apparatus **characterized by** comprising:

a nozzle (503) for injecting a fluid; and
an operation section (504, 505) for butting said nozzle (503) against a sample (50) or inserting said nozzle (503) into the sample (50),

wherein in a state in which said nozzle (503) is being butted against the sample (50) or inserted into the sample (50), the sample (50) is separated while injecting the fluid from said nozzle (503).

**2.** The apparatus according to claim 1, **characterized in that**

the sample (50) has a separation layer (12), and
said operation section (504, 505) butts said nozzle (503) against a peripheral portion of the separation layer (12) of the sample (50) or inserts said nozzle (503) into the peripheral portion the separation layer (12) of the sample (50).

**3.** The apparatus according to claim 1, **characterized in that**

the sample (50) has a separation layer (12) and a concave portion on a side surface, and
said operation section (504, 505) butts said nozzle (503) against the concave portion of the sample (50) or inserts said nozzle (503) into the concave portion of the sample (50).

**4.** The apparatus according to any one of claims 1 to 3, **characterized in that** said nozzle (503) has a wedge-shaped portion.

**5.** The apparatus according to any one of claims 1 to 4, **characterized in that** said nozzle (503) has a fluid injection port (503a) at a distal end.

**6.** The apparatus according to any one of claims 1 to 5, **characterized in that**

the apparatus further comprises a rotary drive section (602) for rotating the sample (50) relative to said nozzle (503), and
in the state in which said nozzle (503) is being butted against the sample (50) or inserted into the sample (50), the sample (50) is separated while rotating the sample (50) relative to said nozzle (503) and injecting the fluid from said nozzle (503).

**7.** The apparatus according to any one of claims 1 to 6, **characterized in that** a gas is used as the fluid.

8. The apparatus according to any one of claims 1 to 6, **characterized in that** a liquid is used as the fluid.

9. The apparatus according to claim 2, **characterized in that** the separation layer (12) is a fragile layer.

10. The apparatus according to claim 2, **characterized in that** the separation layer (12) is a layer formed by anodization.

11. The apparatus according to claim 2, **characterized in that** the separation layer (12) is a layer formed by ion implantation.

12. A sample separating method **characterized by** comprising:

    the operation step of butting an injection nozzle (503) against a sample (50) or inserting the nozzle (503) into the sample (50); and
    the separation step of, in a state in which the nozzle (503) is being butted against the sample (50) or inserted into the sample (50), separating the sample (50) while injecting a fluid from the nozzle (503).

13. The method according to claim 12, **characterized in that**

    the sample has a separation layer inside, and in the operation step, the nozzle is butted against a peripheral portion of the separation layer of the sample or inserted into the peripheral portion of the separation layer of the sample.

14. The method according to claim 12, **characterized in that**

    the sample has a separation layer inside and a concave portion on a side surface, and in the operation step, the nozzle is butted against the concave portion of the sample or inserted into the concave portion of the sample.

15. The method according to any one of claims 12 to 14, **characterized in that** the nozzle has a wedge-shaped portion.

16. The method according to any one of claims 12 to 15, **characterized in that** the nozzle has a fluid injection port at a distal end.

17. The method according to any one of claims 12 to 16, **characterized in that** in the separation step, in the state in which the nozzle is being butted against the sample or inserted into the sample, the sample is separated while rotating the sample relative to the nozzle and injecting the fluid from the nozzle.

18. The method according to any one of claims 12 to 17, **characterized in that** a gas is used as the fluid.

19. The method according to any one of claims 12 to 17, **characterized in that** a liquid is used as the fluid.

20. The method according to claim 12, **characterized in that** the separation layer is a fragile layer.

21. The method according to claim 12, **characterized in that** the separation layer is a layer formed by anodization.

22. The method according to claim 12, **characterized in that** the separation layer is a layer formed by ion implantation.

23. A transfer method of transferring a transfer layer on a surface of a first member to a second member, **characterized by** comprising:

    the preparation step of preparing a composite member (50) by bringing the first member (10) having a separation layer (12) and the transfer layer (13) on the separation layer into tight contact with the second member (20);
    the operation step of butting an injection nozzle (503) against the composite member (50) or inserting the nozzle (503) into the composite member (50); and
    the separation step of, in a state in which the nozzle (503) is being butted against the composite member (50) or inserted into the composite member (50), separating the composite member (50) at the separation layer (12) while injecting a fluid from the nozzle (503), thereby transferring the transfer layer (13) of the first member (10) to the second member (20).

24. A substrate manufacturing method **characterized by** comprising:

    the preparation step of preparing a bonded substrate stack (50) by bonding a first substrate (10) having a separation layer (12) and a transfer layer (13) on the separation layer to a second substrate (20);
    the operation step of butting an injection nozzle (503) against the bonded substrate stack (50) or inserting the nozzle (503) into the bonded substrate stack (50); and
    the separation step of, in a state in which the nozzle (503) is being butted against the bonded substrate stack (50)or inserted into the bonded substrate stack (50), separating the bonded substrate stack (50) at the separation layer (12) while injecting a fluid from the nozzle (503), thereby transferring the transfer layer (13) of the first substrate (10) to the second substrate (20).

25. The method according to claim 24, **characterized in that** the transfer layer includes a single-crystal Si layer (13).

26. The method according to claim 25, **characterized in that** the transfer layer has, in addition to the single-crystal Si layer (13), an insulating layer (14) on the single-crystal Si layer (13).

27. The method according to any one of claims 24 to 26, **characterized in that** the nozzle has a wedge-shaped portion.

28. The method according to any one of claims 24 to 26, **characterized in that** the nozzle has a fluid injection port at a distal end.

29. The method according to any one of claims 24 to 28, **characterized in that** in the separation step, in the state in which the nozzle (503) is being butted against the bonded substrate stack (50) or inserted into the bonded substrate stack (50), the bonded substrate stack (50) is separated while rotating the bonded substrate stack (50) relative to the nozzle (503) and injecting the fluid from the nozzle (503).

30. The method according to any one of claims 24 to 29, **characterized in that** a gas is used as the fluid.

31. The method according to any one of claims 24 to 29, **characterized in that** a liquid is used as the fluid.

32. The method according to any one of claims 24 to 31, **characterized in that** the separation layer is a fragile layer.

33. The method according to any one of claims 24 to 32, **characterized in that** the separation layer is a layer formed by anodization.

34. The method according to any one of claims 24 to 32, **characterized in that** the separation layer is a layer formed by ion implantation.

35. A semiconductor device manufacturing method **characterized by** comprising:

the step (Figs. 1A to 1E) of preparing an SOI substrate using the substrate manufacturing method of claim 24; and
the step (Figs. 10A to 10D) of element-isolating an SOI layer of the SOI substrate and forming a transistor on the element-isolated SOI layer.

36. The method according to claim 35, **characterized in that** the transistor is a partial depletion type FET.

37. The method according to claim 35, **characterized in that** the transistor is a complete depletion type FET.

38. A semiconductor device having a transistor, which is obtained by the manufacturing method of any one of claims 35 to 37.

39. A nozzle (503) used to separate a sample, **characterized by** comprising
a wedge-shaped portion having a fluid injection port (503a) at a distal end.

40. A nozzle (503) used to separate at a separation layer (12) a sample (50) having the separation layer (12) inside, **characterized by** comprising
a wedge-shaped portion having a fluid injection port (503a) at a distal end.

FIG. 1A

FIG. 1B

FIG. 1C

FIG. 1D

FIG. 1E

# F I G. 2

FIG. 3

# F I G. 4

EP 1 197 987 A2

FIG. 5

# F I G. 6

# F I G. 7

# F I G.  8

# FIG. 9

50

503

601

600

602

FIG. 10A

FIG. 10B

FIG. 10C

FIG. 10D